# EUROPEAN PATENT APPLICATION

(11) **EP 4 468 597 A1**
(43) Date of publication of application: **27.11.2024**
(21) Application number: 24167214.6
(22) Date of filing: 28.03.2024
(51) Int. Cl.: H03F 1/02, H03F 1/32, H03F 3/189, H03F 3/24

(54) **WIRELESS COMMUNICATION DEVICE WHICH ADJUSTS ENVELOPE DELAY AMOUNT**

(30) Priority: 22.05.2023 KR 20230065886; 19.09.2023 KR 20230125006
(71) Applicant: Samsung Electronics Co., Ltd., Suwon-si, Gyeonggi-do 16677 (KR)
(72) Inventor: YEON, Haedong, 16677 Suwon-si (KR); DO, Joohyun, 16677 Suwon-si (KR); YU, Hyunseok, 16677 Suwon-si (KR)
(74) Representative: Marks & Clerk LLP

(57) **Abstract**

A wireless communication device includes: a transmission path circuit configured to generate a radio frequency (RF) output signal, based on a transmission signal and a supply voltage tracking an envelope signal; a feedback path circuit configured to be connected to the transmission path circuit so as to receive the RF output signal as a feedback signal, when switching from normal mode to calibration mode; a time domain-based measurement circuit configured to generate, in the calibration mode, an adjacent channel leakage ratio for a reception signal based on a time domain; and at least one processor configured to adjust, in the calibration mode, an envelope delay amount for the envelope signal, based on the adjacent channel leakage ratio.

## Description

### BACKGROUND

The disclosure relates to wireless communication, and particularly, to a wireless communication device that transmits a radio frequency (RF) signal, based on envelope tracking modulation.

Technologies, such as envelope tracking (ET)-related technology, can improve the power consumption efficiency of transmitters of wireless communication devices.

In the ET-related technology, a transmission signal (or, inphase/quadrature (I/Q) signal) and an envelope signal corresponding to the transmission signal are input to a power amplifier of the transmitter of a wireless communication device through different paths from each other. In this case, because the envelope signal corresponds to the bias of the power amplifier that amplifies the transmission signal, a timing matching between the envelope signal and the transmission signal is very important. When a timing mismatch occurs between the envelope signal and the transmission signal as they pass through different paths, the transmission performance and the power consumption efficiency of the transmitter may be reduced.

In a comparative example, timing matching between the envelope signal and the transmission signal is achieved by adjusting a delay amount (or, envelope delay amount) of the envelope signal. In such a comparative example, a calibration operation to adjust a delay amount of an envelope signal may be performed in the mass production stage of a wireless communication device.

As a specific example, in the mass production stage of the wireless communication device, in order to adjust the delay amount of the envelope signal, a feedback path circuit designed within the wireless communication device is connected to fast Fourier transform (FFT)-related blocks operating in the frequency domain of a reception path circuit. Thus, the feedback path circuit measures an adjacent channel leakage ratio (in short, ACLR) for a transmission signal output from a transmission path circuit. In the mass production stage, an operation of adjusting a delay amount of an envelope signal based on the measured adjacent channel leakage ratio may be repeated to determine an optimal delay amount of the envelope signal which minimizes the adjacent channel leakage ratio.

However, in the comparative example described above, because the reception path circuit must continuously perform an operation of receiving signals for communication after the mass production stage of the wireless communication device, the use of the feedback path circuit in the FFT-related blocks of the reception path circuit measuring an adjacent channel leakage ratio for the transmission signal is limited. Thus, real-time measurement of the adjacent channel leakage ratio is not possible. In addition, in order to measure the adjacent channel leakage ratio for the transmission signal in the frequency domain by using the FFT-related blocks of the reception path circuit, additional operations may be required to remove a cyclic prefix (CP) of the transmission signal and synchronize symbols. Furthermore, rather than using FFT-related blocks specialized for measuring the adjacent channel leakage ratio to adjust the delay amount of the envelope signal, the FFT-related blocks of the reception path circuit that perform general reception operations are used, and thus, there is a difficulty in that implementing calibration software and the debugging of the calibration software become complicated.

### SUMMARY

Provided is a wireless communication device in which the complexity of a circuit for adjusting an envelope delay amount is minimized. In the disclosure, the efficiency of envelope tracking-related technology is maximized by adjusting the envelope delay amount in real time.

According to an aspect of the disclosure, a wireless communication device includes: at least one processor configured to output a first transmission signal, and delay a first envelope signal corresponding to the first transmission signal by an envelope delay amount and output the delayed first envelope signal; a transmission path circuit configured to generate a first radio frequency (RF) output signal, based on the first transmission signal and a supply voltage tracking the first envelope signal; a feedback path circuit configured to generate a first reception signal by receiving the first RF output signal as a first feedback signal; and a time domain-based measurement circuit configured to generate an adjacent channel leakage ratio for the first reception signal in a time domain, wherein the at least one processor is further configured to adjust the envelope delay amount, based on the adjacent channel leakage ratio.

According to an aspect of the disclosure, a wireless communication device includes: a transmission path circuit configured to generate a radio frequency (RF) output signal, based on a transmission signal and a supply voltage tracking an envelope signal; a feedback path circuit configured to be connected to the transmission path circuit so as to receive the RF output signal as a feedback signal, when switching from normal mode to calibration mode; a time domain-based measurement circuit configured to generate, in the calibration mode, an adjacent channel leakage ratio for a reception signal based on a time domain; and at least one processor configured to adjust, in the calibration mode, an envelope delay amount for the envelope signal, based on the adjacent channel leakage ratio.

According to an aspect of the disclosure, a wireless communication device includes: a transmission path circuit configured to generate a radio frequency (RF) output signal, based on a transmission signal and a supply voltage tracking an envelope signal; a feedback path circuit configured to generate a reception signal by receiving the RF output signal as a feedback signal; a time domain-based measurement circuit configured to generate, based on a time domain, an adjacent channel leakage ratio for the reception signal by using a lowpass filter having a narrower bandwidth than an inband of the reception signal; and at least one processor configured to adjust an envelope delay amount for the envelope signal, based on the adjacent channel leakage ratio.

At least some of the above and other features of the invention are set out in the claims.

### BRIEF DESCRIPTION OF DRAWINGS

Embodiments of the disclosure will be more clearly understood from the following detailed description taken in conjunction with the accompanying drawings in which:
FIG. 1 illustrates a wireless communication device according to an embodiment;
FIG. 2 illustrates an operating procedure of a wireless communication device, according to an embodiment;
FIG. 3 illustrates details of a processor of FIG. 1;
FIG. 4 illustrates a wireless communication device according to an embodiment;
FIG. 5 illustrates an operating procedure of a wireless communication device, according to an embodiment;
FIG. 6 illustrates a feedback path circuit according to an embodiment;
FIGS. 7A and 7B illustrates feedback processing circuits according to an embodiment;
FIG. 8 illustrates a time domain-based measurement circuit according to an embodiment;
FIG. 9 illustrates frequency characteristics of a first reception signal of FIG. 7;
FIG. 10 illustrates an operation of a time domain-based measurement circuit in FIG. 7;
FIG. 11 illustrates an operation of setting a low pass filter, according to an embodiment;
FIGS. 12A and 12B illustrate an operation of setting a low pass filter, according to an embodiment;
FIG. 13 illustrates an operating procedure of a wireless communication device, according to an embodiment;
FIGS. 14A and 14B illustrate an embodiment of a wireless communication device, according to an embodiment;
FIG. 15 illustrates another embodiment of a wireless communication device, according to an embodiment;
FIG. 16 illustrates an Internet of Things (IoT) device to which a wireless communication device is applied, according to an embodiment; and
FIG. 17 illustrates a user equipment (a wireless communication device), according to an embodiment.

### DETAILED DESCRIPTION

Hereinafter, embodiments are described in detail with reference to the accompanying drawings.

The terms as used in the disclosure are provided to merely describe specific embodiments, not intended to limit the scope of other embodiments. Singular forms include plural referents unless the context clearly dictates otherwise. The terms and words as used herein, including technical or scientific terms, may have the same meanings as generally understood by those skilled in the art. The terms as generally defined in dictionaries may be interpreted as having the same or similar meanings as or to contextual meanings of the relevant art. Unless otherwise defined, the terms should not be interpreted as ideally or excessively formal meanings. Even though a term is defined in the disclosure, the term should not be interpreted as excluding embodiments of the disclosure under circumstances.

The term "couple" and the derivatives thereof refer to any direct or indirect communication between two or more elements, whether or not those elements are in physical contact with each other. The terms "transmit", "receive", and "communicate" as well as the derivatives thereof encompass both direct and indirect communication. The terms "include" and "comprise", and the derivatives thereof refer to inclusion without limitation. The term "or" is an inclusive term meaning "and/or". The phrase "associated with," as well as derivatives thereof, refer to include, be included within, interconnect with, contain, be contained within, connect to or with, couple to or with, be communicable with, cooperate with, interleave, juxtapose, be proximate to, be bound to or with, have, have a property of, have a relationship to or with, or the like. The term "controller" refers to any device, system, or part thereof that controls at least one operation. The functionality associated with any particular controller may be centralized or distributed, whether locally or remotely. The phrase "at least one of," when used with a list of items, means that different combinations of one or more of the listed items may be used, and only one item in the list may be needed. For example, "at least one of A, B, and C" includes any of the following combinations: A, B, C, A and B, A and C, B and C, and A and B and C, and any variations thereof. The expression "at least one of a, b, or c" may indicate only a, only b, only c, both a and b, both a and c, both b and c, all of a, b, and c, or variations thereof. Similarly, the term "set" means one or more. Accordingly, the set of items may be a single item or a collection of two or more items.

Moreover, multiple functions described below can be implemented or supported by one or more computer programs, each of which is formed from computer readable program code and embodied in a computer readable medium. The terms "application" and "program" refer to one or more computer programs, software components, sets of instructions, procedures, functions, objects, classes, instances, related data, or a portion thereof adapted for implementation in a suitable computer readable program code. The phrase "computer readable program code" includes any type of computer code, including source code, object code, and executable code. The phrase "computer readable medium" includes any type of medium capable of being accessed by a computer, such as Read Only Memory (ROM), Random Access Memory (RAM), a hard disk drive, a Compact Disc (CD), a Digital Video Disc (DVD), or any other type of memory. A "non-transitory" computer readable medium excludes wired, wireless, optical, or other communication links that transport transitory electrical or other signals. A non-transitory computer readable medium includes media where data can be permanently stored and media where data can be stored and later overwritten, such as a rewritable optical disc or an erasable memory device.

The embodiments may be described and illustrated in terms of blocks, as shown in the drawings, which carry out a described function or functions. These blocks, which may be referred to herein as radio frequency (RF) module or the like may be physically implemented by analog and/or digital circuits including one or more of a logic gate, an integrated circuit, a microprocessor, a microcontroller, a memory circuit, a passive electronic component, an active electronic component, an optical component, and the like. The circuits may, for example, be embodied in one or more semiconductor chips, or on substrate supports such as printed circuit boards and the like. Circuits included in a block may be implemented by dedicated hardware, or by a processor (e.g., one or more programmed microprocessors and associated circuitry), or by a combination of dedicated hardware to perform some functions of the block and a processor to perform other functions of the block. Each block of the embodiments may be physically separated into two or more interacting and discrete blocks. Likewise, the blocks of the embodiments may be physically combined into more complex blocks.

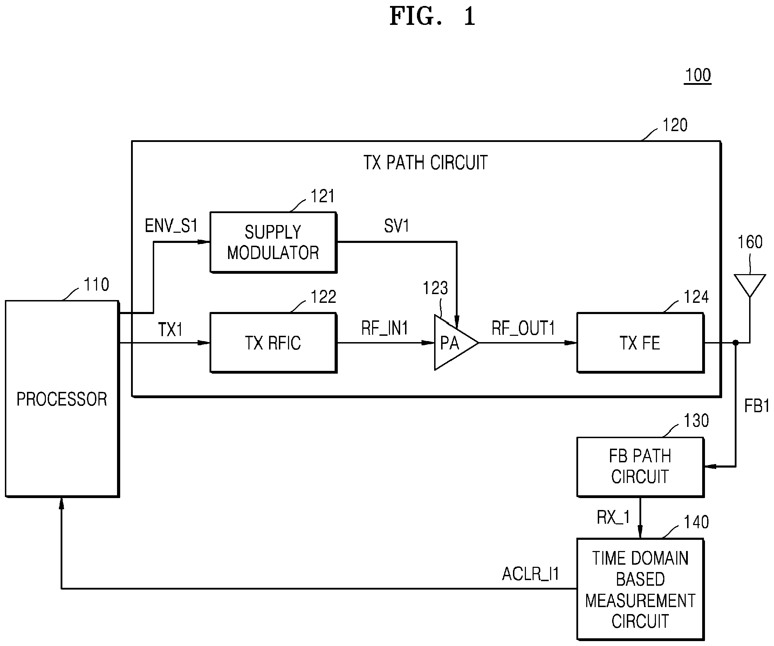

FIG. 1 is a block diagram schematically illustrating a wireless communication device 100 according to an embodiment.

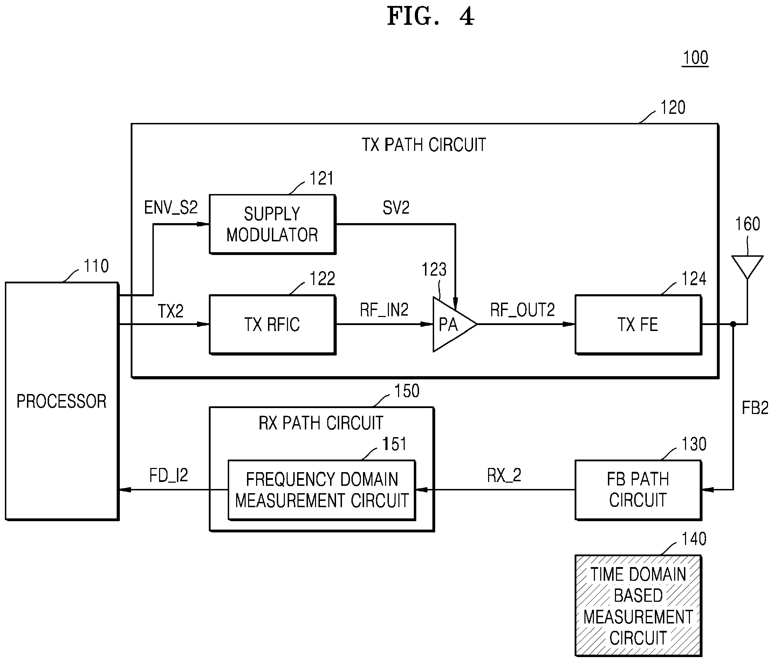

Referring to FIG. 1, the wireless communication device 100 may include a processor 110, a transmission path circuit 120, a feedback path circuit 130, a time domain-based measurement circuit 140, and an antenna 160. Although elements of the wireless communication device 100 that are necessary to describe the technical ideas of the disclosure are shown in FIG. 1, this is only an example. Embodiments of the disclosure are not limited thereto. In addition, the wireless communication device 100 may include a reception path circuit for receiving a radio frequency (RF) signal, and this is described below with reference to FIG. 4. Throughout the disclosure, the processor 110 is at least one processor that may include or correspond to circuitry like a central processing unit (CPU), a microprocessor unit (MPU), an application processor (AP), a coprocessor (CP), a system-on-chip (SoC), or an integrated circuit (IC).

The wireless communication device 100 may access a wireless communication system by transmitting and receiving RF signals through the antenna 160. The wireless communication system accessible from the wireless communication device 100 may include a cellular network, such as a new radio (NR) system, a long term evolution (LTE) system, an LTE-Advanced system, a code division multiple access (CDMA) system, or a global system for mobile communication (GSM) system, a wireless local area network (WLAN) system, or any other wireless communication system.

In the disclosure, the wireless communication device 100 may refer to any device that accesses a wireless communication system. The wireless communication device 100 may be stationary or mobile, and may refer to any device that transmits and receives data and/or control information by communicating with a base station. For example, the wireless communication device 100 may be referred to as user equipment, terminal equipment, a mobile station (MT), a user terminal (UT), a subscribe station (SS), a wireless device, a handheld device, etc.

The antenna 160 may be connected to the transmission path circuit 120 to transmit a signal provided from the transmission path circuit 120 to another device (wireless communication device or base station), or to provide a signal received from another device to the reception path circuit. In some embodiments, the antenna 160 may include a plurality of antenna elements for phased array or multiple-input and multiple-output (MIMO).

The processor 110 may generate a signal including information to be transmitted through the antenna 160. In addition, the processor 110 may process the signal received through the antenna 160 and obtain information included in the signal. In some embodiments, the processor 110 may be referred to as a baseband processor or modem.

In an embodiment, the processor 110 may select one of a normal mode and a calibration mode, and control an operation according to the selected mode. In the disclosure, the normal mode may refer to a mode for performing a general communication operation, for example a mode for performing wireless communication, and the calibration mode may refer to a mode for adjusting an envelope delay amount to determine an optimal envelope delay amount. In some embodiments, in the calibration mode, an operation of adjusting a value of at least one transmission parameter of the transmission path circuit 120 may be further performed. In the disclosure, the transmission parameter may correspond to any of parameters that may be set in elements of the transmission path circuit.

In an embodiment, the processor 110 may (periodically or aperiodically) switch from the normal mode to the calibration mode. In the calibration mode, the processor 110 may adjust the envelope delay amount by using the feedback path circuit 130 and the time domain-based measurement circuit 140. In some embodiments, the wireless communication device 100 operates in calibration mode.

In an embodiment, the processor 110 may output a first transmission signal TX1, and delay a first envelope signal ENV_S1 corresponding to the first transmission signal TX1 by a certain envelope delay amount and output the signal. The first transmission signal TX1 and the first envelope signal ENV_S1 may be provided to the transmission path circuit 120.

In an embodiment, the transmission path circuit 120 may include a supply modulator 121, a transmission radio frequency integrated circuit (TX RFIC) 122, a power amplifier 123, and a transmission front-end circuit (TX FE) 124. In the disclosure, the transmission path circuit 120 may include elements for generating an RF output signal from the transmission signal provided from the processor 110. In some embodiments, the transmission path circuit 120 may be referred to as a transmitter or transmission chain. In the disclosure, the expression "TX" may refer to "transmission", the expression "RX" may refer to "reception", and the expression "FB" may refer to "feedback".

In an embodiment, the supply modulator 121 may receive the first envelope signal ENV_S1, and based on ENV_S1, generate a first supply voltage SV1 modulated so that a level dynamically changes according to the first envelope signal ENV_S1, and provide the voltage to the power amplifier (PA) 123. The TX RFIC 122 may receive the first transmission signal TX1, and based on TX1, generate a first RF input signal RF_IN1 and provide the signal to the power amplifier 123. In some embodiments, the transmission RFIC 122 may include a mixer, a filter, or else.

In an embodiment, the power amplifier 123 may be biased by the first supply voltage SV1 to amplify the first RF input signal RF_IN1, and as a result, generate a first RF output signal RF_OUT1. The transmission front-end circuit 124 may route the first RF output signal RF_OUT1 to the antenna 160. In addition, the transmission front-end circuit 124 may be connected to the feedback path circuit 130 so as to provide the first RF output signal RF_OUT1 (as a first feedback signal FB1) to the feedback path circuit 130.

In an embodiment, the feedback path circuit 130 may be connected to the transmission front-end circuit 124 under the control of the processor 110 when switching to the calibration mode.

In an embodiment, the feedback path circuit 130 may be used exclusively in calibration mode. Meanwhile, the feedback path circuit 130 may be used for a calibration operation to adjust a value of at least one transmission parameter of the transmission path circuit 120 in the mass production stage of the wireless communication device 100. In some embodiments, the feedback path circuit 130 may include some elements of a circuit used in normal mode.

In an embodiment, the feedback path circuit 130 may receive the first feedback signal FB1 and generate a first reception signal RX_1, which is an intermediate output. In the disclosure, the intermediate output of the feedback path circuit 130 may refer to a signal output from an internal node between specific processing circuits included in the feedback path circuit 130.

In an embodiment, the time domain-based measurement circuit 140 may generate an `adjacent channel leakage ratio' (e.g., ACLR_I1 in FIG. 1) for the first reception signal RX_1 in the time domain. In the disclosure, generating the adjacent channel leakage ratio may also be referred to as measuring the adjacent channel leakage ratio. The time domain-based measurement circuit 140 may perform a plurality of frequency down-conversions on the first reception signal RX_1 based on a plurality of center frequencies, perform low pass filtering on results of the conversions, and measure inband power and first outband power / second outband power by using results of the filtering. In the disclosure, an 'inband' may refer to a frequency band that matches a carrier frequency of an RF output signal, while an 'outband' may refer to a frequency adjacent to the inband. In addition, inband power may refer to power calculated and accumulated for a certain period of time within the inband, while outband power may refer to power calculated and accumulated for a certain period of time within the outband.

In an embodiment, the time domain-based measurement circuit 140 may generate (measure) an adjacent channel leakage ratio including a difference between a first difference between the inband power and a first outband power and a second difference between the inband power and a second outband power. When measuring the inband power and the first and second outband powers, the time domain-based measurement circuit 140 may consider (e.g. may assess) a timing related to an uplink signal corresponding to the first RF output signal RF_OUT1. In addition, the time domain-based measurement circuit 140 may provide a gap time between a plurality of measurement operations to (effectively) perform a plurality of measurement operations for measuring inband power and the first outband power / the second outband power. The time domain-based measurement circuit 140 may provide first information ACLR_I1 indicating the generated adjacent channel leakage ratio, to the processor 110.

In an embodiment, the processor 110 may adjust the envelope delay amount based on the first information ACLR_I1. Specifically, the processor 110 may adjust the envelope delay amount as the first difference and the second difference become similar to each other and each amount of the first difference and the second difference decreases. The processor 110 may repeat the operations described above, starting with outputting the first transmission signal TX1 and the first envelope signal ENV_S1 based on the adjusted envelope delay amount.

In an embodiment, the processor 110 may determine a final envelope delay amount, as a result of repeatedly adjusting the envelope delay amount in calibration mode, and output, in normal mode, a transmission signal and an envelope signal corresponding to the transmission signal, based on the final envelope delay amount.

According to an embodiment, the wireless communication device 100 dynamically switches from a normal mode for performing a communication operation to a calibration mode for adjusting an envelope delay amount and performs an operation for optimizing the envelope delay amount, thereby improving the transmission performance of the wireless communication device 100. In addition, the wireless communication device 100 measures an adjacent channel leakage ratio in the time domain to adjust the adjacent channel leakage ratio, thereby significantly reducing the complexity of measuring the adjacent channel leakage ratio compared to a related-art configuration of measuring the adjacent channel leakage ratio in the frequency domain.

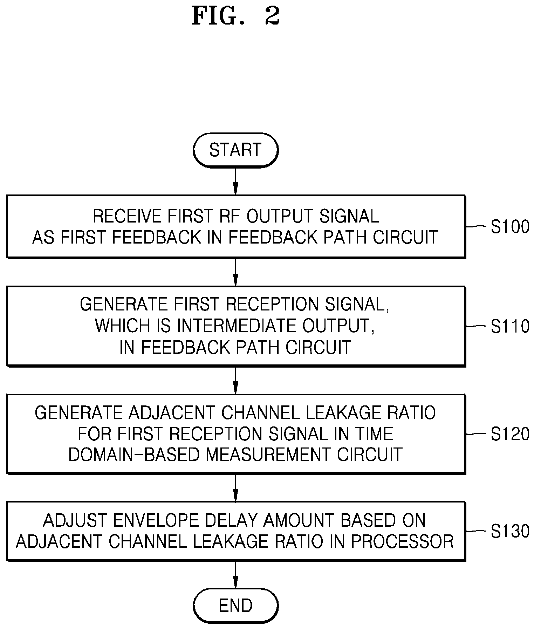

FIG. 2 is a flowchart of an operating procedure of a wireless communication device, according to an embodiment. In an embodiment described below, the wireless communication device operates in calibration mode.

Referring to FIG. 2, in operation S 100, a first RF output signal may be received as a first feedback signal in a feedback path circuit of the wireless communication device. For example, the feedback path circuit may be connected to the transmission path circuit, in calibration mode, to receive the first RF output signal output from the transmission path circuit as the first feedback signal.

In operation S 110, a first reception signal, which is an intermediate output, may be generated in the feedback path circuit of the wireless communication device. For example, the feedback path signal may include a plurality of processing circuits for performing a processing operation on signals in the mass production stage of the wireless communication device. The feedback path circuit may generate the first reception signal by passing the first feedback through only a part of the plurality of processing circuits. For example, the plurality of processing circuits of the feedback path circuit may all be activated in the mass production stage of the wireless communication device. Only a part of the plurality of processing circuits may be activated after the mass production stage. In the disclosure, "after the mass production stage" may refer to an operation in which the wireless communication device is sold to a user and used by the user. For example, operations performed "after the mass production stage" may be operations performed during operation of the wireless communication device by a user. In an embodiment, a part of the plurality of processing circuits may include at least one of a direct current (DC) offset calibration circuit and an inphase/quadrature (I/Q) mismatch calibration circuit.

In operation S 120, an adjacent channel leakage ratio for the first reception signal may be generated in a time domain-based measurement circuit (e.g., the time domain based measurement circuit 140 in FIG. 1) of the wireless communication device. For example, the time domain-based measurement circuit may perform a plurality of frequency down-conversions on the first reception signal based on a plurality of center frequencies, perform low pass filtering on results of the conversions, measure inband power and first and second outband powers by using results of the filtering, and generate an adjacent channel leakage ratio based on a result of the measurement. The time domain-based measurement circuit may provide first information indicating the adjacent channel leakage ratio, to a processor of the wireless communication device.

In operation S130, an envelope delay amount may be adjusted by the processor of the wireless communication device based on the adjacent channel leakage ratio.

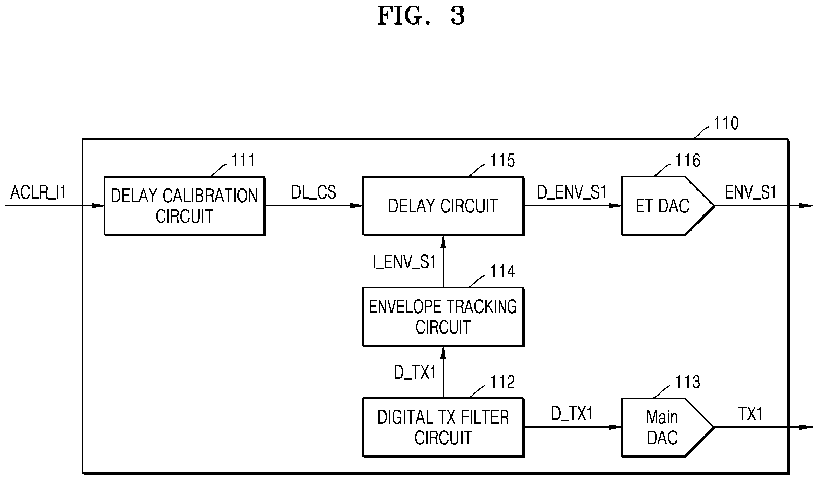

FIG. 3 is a block diagram illustrating details of the processor 110 of FIG. 1.

Although elements of the processor 110 that are necessary to describe the technical ideas of the disclosure are shown in FIG. 3, this is only an example, and it could be fully understood that embodiments are not limited thereto.

Referring to FIG. 3, the processor 110 may include a delay calibration circuit 111, a digital transmission filter circuit 112, a main digital-to-analog converter (DAC) 113, an envelope tracking circuit 114, a delay circuit 115, and an envelope DAC 116.

In an embodiment, the delay calibration circuit 111 may adjust an envelope delay amount based on the first information ACLR_I1 provided from the time domain-based measurement circuit 140 (see FIG. 1). The delay calibration circuit 111 may generate a delay control signal DL_CS corresponding to the adjusted envelope delay amount, and provide the generated signal to the delay circuit 115.

In an embodiment, the digital transmission filter circuit 112 may generate a first digital transmission signal D_TX1, and provide the generated signal to the envelope tracking circuit 114 and the main DAC 113.

In an embodiment, the envelope tracking circuit 114 may generate a first initial envelope signal I_ENV_S1 by detecting an envelope corresponding to the first digital transmission signal D_TX1, and provide the generated signal to the delay circuit 115.

In an embodiment, the delay circuit 115 may generate a first delayed envelope signal D_ENV_S1 by delaying the first initial envelope signal I_ENV_S1 based on the delay control signal DL_CS, and provide the generated signal to the envelope DAC 116.

In an embodiment, the main DAC 113 may convert the first digital transmission signal D_TX1 to the first transmission signal TX1, which is an analog signal, and output the first transmission signal TX1, and the envelope DAC 116 may convert the first delayed envelope signal D_NV_S1 to the first envelope signal ENV_S1, which is an analog signal, and output the first envelope signal ENV_S1. Through the above described operations, the processor 110 may output the first transmission signal TX1 and the first envelope signal ENV_S1 corresponding to the adjusted envelope delay amount.

FIG. 4 is a block diagram schematically illustrating a wireless communication device 100 according to an embodiment.

In FIG. 4, the wireless communication device 100 in the mass production stage is shown, and the feedback path circuit 130 may be used for a calibration operation to adjust a value of at least one transmission parameter of the transmission path circuit 120. In some embodiments, an operation of adjusting an envelope delay amount by using the feedback path circuit 130 and the time domain-based measurement circuit 140 described above with reference to FIG. 1 may be performed even in the mass production stage. Below, an operation of the wireless communication device 100 in the mass production stage is mainly described, and descriptions overlapping those of FIG. 1 are omitted.

Referring to FIG. 4, in the mass production stage, the feedback path circuit 130 may be connected to a frequency domain-based measurement circuit 151 of the reception path circuit 150.

In an embodiment, the processor 110 may output a second transmission signal TX2, and delay a second envelope signal ENV_S2 corresponding to the second transmission signal TX2 by a certain envelope delay amount and output the delayed second envelope signal. The second transmission signal TX2 and the second envelope signal ENV_S2 may be provided to the transmission path circuit 120. In some embodiments, in the mass production stage, an external test device may perform a calibration operation, instead of the processor 110.

In an embodiment, the supply modulator 121 may receive the second envelope signal ENV_S2, and based on this, generate a second supply voltage SV2 modulated so that a level dynamically changes according to the second envelope signal ENV_S2, and provide the generated voltage to the power amplifier 123. The transmission RFIC 122 may receive the second transmission signal TX2, and based on this, generate a second RF input signal RF_IN2 and provide the generated signal to the power amplifier 123.

In an embodiment, the power amplifier 123 may be biased by the second supply voltage SV2 to amplify the second RF input signal RF_IN2. As a result, the power amplifier 123 may generate a second RF output signal RF_OUT2. The transmission front-end circuit 124 may route the second RF output signal RF_OUT2 to the antenna 160. In addition, the transmission front-end circuit 124 may be connected to the feedback path circuit 130 to provide the second RF output signal RF_OUT2 as a second feedback signal FB2 to the feedback path circuit 130.

In an embodiment, the feedback path circuit 130 may be temporarily connected to the transmission front-end circuit 124 in the mass production stage.

In an embodiment, the feedback path circuit 130 may receive the second feedback signal FB2 and generate a second reception signal RX_2, which is a final output. In the disclosure, the final output of the feedback path circuit 130 may refer to a signal output from a processing circuit arranged at the end from among processing circuits included in the feedback path circuit 130 and connected to each other in series.

In an embodiment, the frequency domain-based measurement circuit 151 may perform a measuring operation on the second reception signal RX_2 in the frequency domain. For example, the frequency domain-based measurement circuit 151 may remove a CP of the second reception signal RX_2, perform FFT, and then, calculate and accumulate the power of a result of the transformation. The frequency domain-based measurement circuit 151 may provide second information FD_I2 indicating a measurement result for the second reception signal RX_2, to the processor 110.

In an embodiment, the processor 110 may adjust a value of at least one transmission parameter of the transmission path circuit 120 based on the second information FD_I2. The transmission path circuit 120 may repeat the operations described above, starting with generating the second RF output signal RF_OUT2 based on the at least one transmission parameter having the adjusted value.

In an embodiment, the processor 110 may determine a value of at least one transmission parameter as a result of repeatedly adjusting the value of the at least one transmission parameter of the transmission path circuit 120, and the at least one transmission parameter may be set to the determined value.

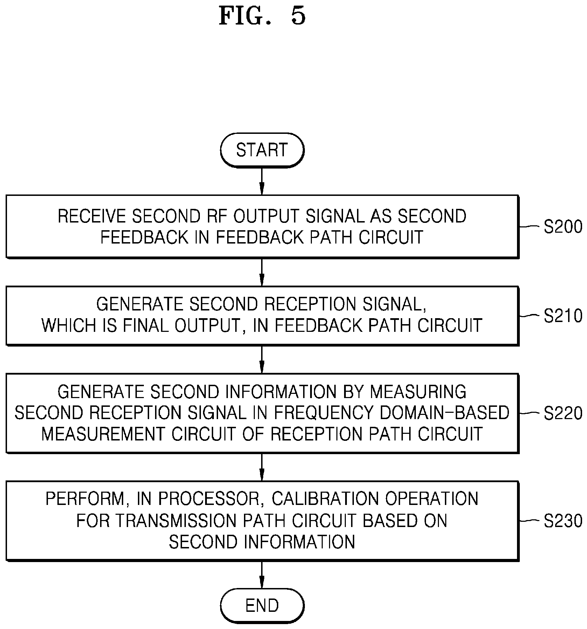

FIG. 5 is a flowchart of an operating procedure of a wireless communication device, according to an embodiment. In the embodiment described below, a wireless communication device is in the mass production stage.

Referring to FIG. 5, in operation S200, a second RF output signal may be received as second feedback in a feedback path circuit of the wireless communication device. For example, the feedback path circuit may be connected to the transmission path circuit, in the mass production stage, to receive the second RF output signal output from the transmission path circuit as the second feedback.

In operation S210, a second reception signal, which is a final output, may be generated in the feedback path circuit of the wireless communication device. For example, the feedback path signal may include a plurality of processing circuits for performing a processing operation on signals in the mass production stage of the wireless communication device. The feedback path circuit may generate the second reception signal by passing the second feedback through all of the plurality of processing circuits. In an embodiment, the plurality of processing circuits may include a DC offset calibration circuit, an I/O mismatch calibration circuit, and a decimation filter, etc.

In operation S220, second information may be generated by measuring the second reception signal in the frequency domain-based measurement circuit of a reception path circuit of the wireless communication device. For example, the feedback path circuit may be temporarily connected to the frequency domain-based measurement circuit in the mass production stage, and after the mass production stage, the feedback path circuit may not be connected to the frequency domain-based measurement circuit.

In operation S230, a processor of the wireless communication device may perform a calibration operation on a transmission path circuit based on the second information. For example, the processor may adjust a value of at least one transmission parameter of the transmission path circuit based on the second information.

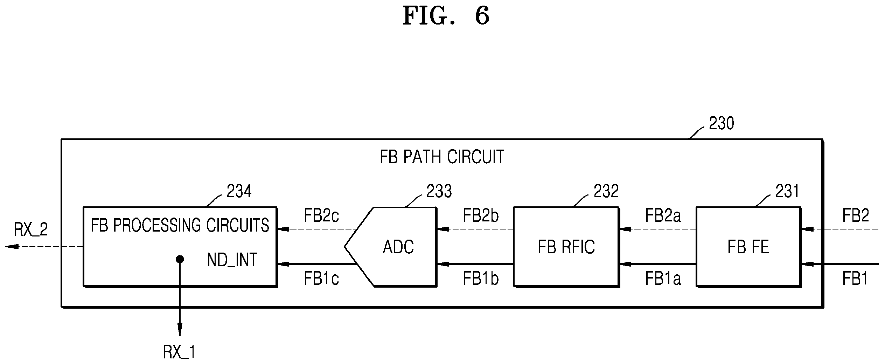

FIG. 6 is a block diagram of a feedback path circuit 230 according to an embodiment. In FIG. 6, the flow of a solid line signal indicates a signal flow in the calibration mode after the mass production stage, and the flow of a dotted line signal indicates a signal flow in the mass production stage. An embodiment of the feedback path circuit 230 in FIG. 6 is only an example. Embodiments of the disclosure are not limited thereto.

Referring to FIG. 6, the feedback path circuit 230 may include a feedback front-end circuit (FB FE) 231, a feedback RFIC (FB RFIC) 232, an analog to digital converter (ADC) 233, and feedback processing circuits (FB PROCESSING CIRCUITS) 234.

In the calibration mode after the mass production stage, the feedback front-end circuit 231 may receive the first feedback signal FB1 and route the received first feedback signal FB1 to the feedback RFIC 232 as first "a" feedback signal FB1a. The feedback RFIC 232 may receive the first a feedback signal FB1a, perform preprocessing operations such as low noise amplification, and then, provide first "b" feedback signal FB1b to the ADC 233. The ADC 233 may convert the first b feedback signal FB1b into first "c" feedback signal FB1c, which is a digital signal, and provide the first c feedback signal FB1c to the feedback processing circuits 234. The feedback processing circuits 234 may output the first reception signal RX_1 through an internal node ND_INT. The first reception signal RX_1 may be provided to the time domain-based measurement circuit 140 (see FIG. 1).

In the mass production stage, the feedback front-end circuit 231 may receive the second feedback signal FB2 and route the received second feedback signal FB2 to the feedback RFIC 232 as second "a" feedback signal FB2a. The feedback RFIC 232 may receive the second a feedback signal FB2a, perform preprocessing operations such as low noise amplification, and then provide second "b" feedback signal FB2b to the ADC 233. The ADC 233 may convert the second b feedback signal FB2b into second "c" feedback signal FB2c, which is a digital signal, and provide the second c feedback signal FB2c to the feedback processing circuits 234. The feedback processing circuits 234 may output the second reception signal RX_2 through an output node. The second reception signal RX_2 may be provided to the frequency domain-based measurement circuit 151 (see FIG. 4).

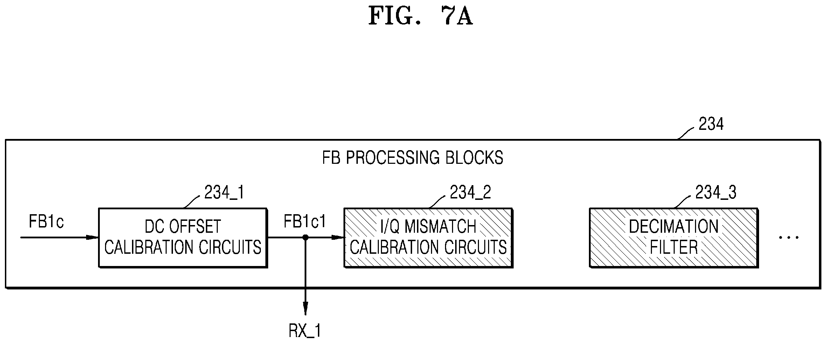

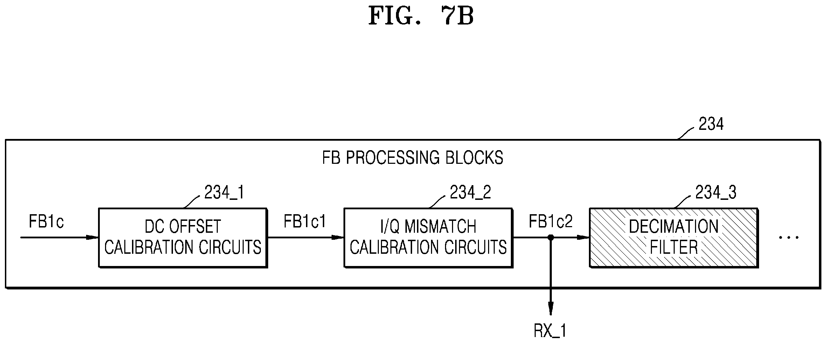

FIGS. 7A and 7B are block diagrams of feedback processing circuits 234 according to an embodiment. The feedback processing circuits 234 in FIGS. 7A and 7B are only examples. Embodiments of the disclosure are not limited thereto, and various blocks may be further included, or some blocks may be omitted.

Referring to FIG. 7A, the feedback processing circuits 234 may include a DC offset calibration circuit 234_1, an I/Q mismatch calibration circuit 234_2, a decimation filter 234_3, and other components.

In an embodiment, the DC offset calibration circuit 234_1 may set an input to zero (0) with respect to received first "c" feedback signal FB1c and add an offset to correct DC offset, to generate first "c 1" feedback signal FB1c1. The first "c 1" feedback signal FB1c1 may be output as the first reception signal RX_1. In an embodiment, the internal node ND_INT in FIG. 6 may correspond to a node between the DC offset calibration circuit 234_1 and the I/O mismatch calibration circuit 234_2. In some embodiments, in FIG. 7A, the I/Q mismatch calibration circuit 234_2, the decimation filter 234_3, which are arranged after the DC offset calibration circuit 234_1, may be deactivated.

In FIG. 7B, the I/Q mismatch calibration circuit 234_2 may calibrate I/Q imbalance with respect to the first "c1" feedback signal FB1c1 received from the DC offset calibration circuit 234_1 to provide first "c2" feedback signal FB1c2. The first "c2" feedback signal FB1c2 may be output as the first reception signal RX_1. In an embodiment, the internal node ND_INT in FIG. 6 may correspond to the I/Q mismatch calibration circuit 234_2 and the decimation filter 234_3. In some embodiments, in FIG. 7B, the decimation filter 234_3 (arranged after the I/Q mismatch calibration circuit 234_2) may be deactivated.

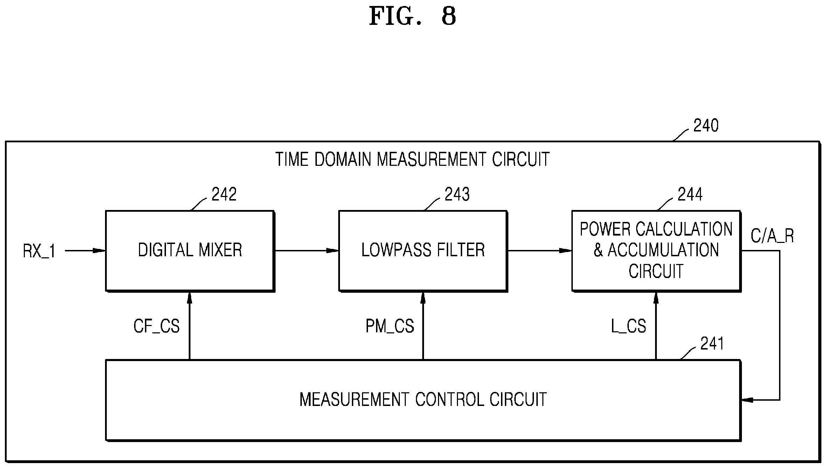

FIG. 8 is a block diagram of a time domain-based measurement circuit 240 according to an embodiment. The time domain-based measurement circuit 240 in FIG. 8 is only an example, and is not limited thereto, and various blocks may be further included, or some blocks may be omitted.

Referring to FIG. 8, the time domain-based measurement circuit 240 may include a measurement control circuit 241, a digital mixer 242, a lowpass filter 243, and a `power calculation & accumulation circuit' 244.

In an embodiment, the digital mixer 242 may perform an operation of frequency down-conversion on the received first reception signal RX_1.

In an embodiment, the lowpass filter 243 may perform an operation of lowpass filtering based on a result of the conversion received from the digital mixer 242.

In an embodiment, the power calculation & accumulation circuit 244 may calculate and accumulate power of a result of the filtration received from the lowpass filter 243. In the disclosure, "calculating and accumulating power" may be referred to as measuring power.

In an embodiment, the measurement control circuit 241 may generate an adjacent channel leakage ratio for the first reception signal RX_1 based on a calculation & accumulation result C/A_R received from the power calculation & accumulation circuit 244.

In an embodiment, the measurement control circuit 241 may generate at least one of a first control signal CF_CS for controlling a center frequency used for frequency down-conversion of the digital mixer 242, a second control signal PM_CS for controlling filter parameters of the lowpass filter 243, and a third control signal L_CS for controlling an operation length of the power calculation & accumulation circuit 244.

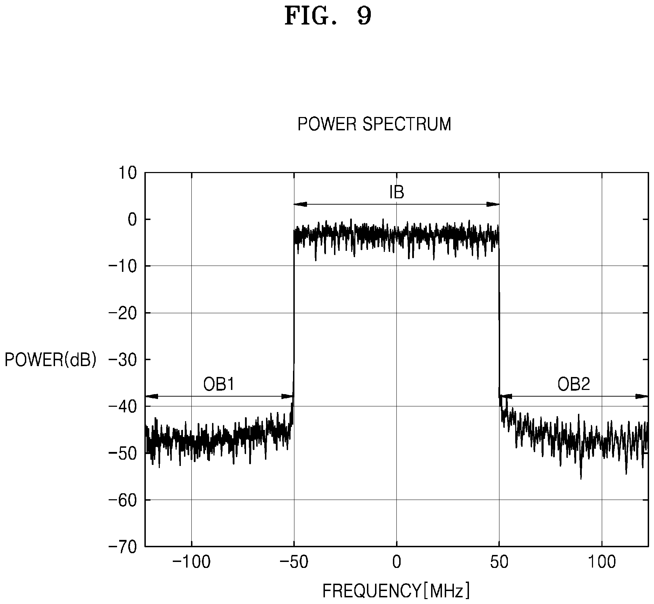

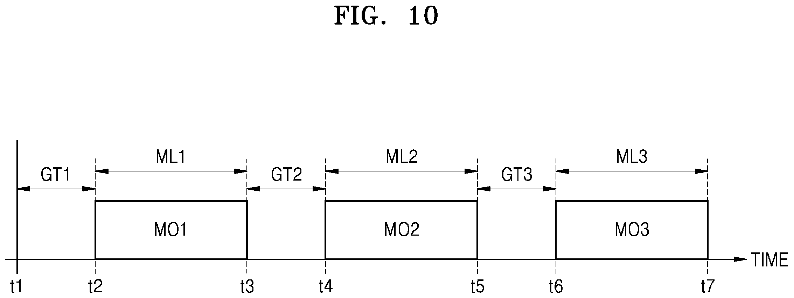

FIG. 9 is a diagram illustrating frequency characteristics of the first reception signal RX_1 in FIG. 7. FIG. 10 is a diagram describing an operation of the time domain-based measurement circuit 240 in FIG. 7.

Referring to FIG. 9, the power of an inband IB of the first reception signal RX_1 may be measured to be higher than the powers of a first outband OB1 and a second outband OB2. An adjacent channel leakage ratio measured in the time domain-based measurement circuit 240 may include a first difference between accumulated power in the inband IB and the accumulated power in the first outband OB1, and a second difference between the accumulated power in the inband IB and the accumulated power in the second outband OB2. In some embodiments, the first outband OB1 may be referred to as a `left outband,' and the second outband OB2 may be referred to as a `right outband.'

In an embodiment, in the lowpass filter 243 in FIG. 8, a value of a first filter parameter may be set so that the lowpass filter 243 has a narrower bandwidth than the inband IB, and a value of a second filter parameter may be set so that the power of the inband IB is measured below a threshold when measuring the power of the first outband OB1 or second outband OB2. Specifically, in the lowpass filter 243, the bandwidth of the lowpass filter 243 may be designed considering a relationship between the bandwidth of the feedback path circuit and a signal bandwidth of the feedback, and may be designed so that the inband IB portion is sufficiently attenuated when measuring outband power.

A detailed operation of the time domain-based measurement circuit 240 is described below with further reference to FIGS. 8 and 10.

In an embodiment, the time domain-based measurement circuit 240 may perform a first measurement operation MO1, a second measurement operation MO2, and a third measurement operation MO3, based on a timing related to an uplink signal for the first RF output signal RF_OUT1 (e.g., shown in FIG. 1) corresponding to the first reception signal RX_1. For example, the time domain-based measurement circuit 240 may start the first measurement operation MO1 at a time "t2" after a first gap time GT1 from time "t1", which is an output time point corresponding to a slot boundary or transmit-time-interval (TTI) boundary of the first RF output signal RF_OUT1 (e.g., shown FIG. 1). The time domain-based measurement circuit 240 may perform the first measurement operation MO1 during a first measurement operation length ML1, and at time "t4" after a second gap time GT2 from time "t3", which is a completion point, start the second measurement operation MO2. The time domain-based measurement circuit 240 may perform the second measurement operation MO2 during a second measurement operation length ML2, and at time "t6" after a third gap time GT3 from time "t5", which is a completion point, start the third measurement operation MO3. The time domain-based measurement circuit 240 may perform the third measurement operation MO3 during a third measurement operation length ML3 and complete at time "t7".

In an embodiment, one of the first measurement operation MO1, the second measurement operation MO2, and the third measurement operation MO3 may measure one of the power in the inband IB and the powers in the first outbound OB1 and the second outband OB2. In an embodiment, the first measurement operation MO1 measures the power in the inband IB, the second measurement operation MO2 measures the power of the first outband OB1, and the third measurement operation MO3 measures the power of the second outband OB2. However, this is only an example to aid understanding, and embodiments are not limited thereto, and an order of measuring the power in the inband IB and the powers in the first and second outbands OB1 and OB2 may vary.

In an embodiment, the first measurement operation MO1 may include an operation of the power calculation & accumulation circuit 244 that measures and accumulates the power in the inband IB of the first reception signal RX_1 that passes through the digital mixer 242 and the lowpass filter 243. The second measurement operation MO2 may include an operation of the power calculation & accumulation circuit 244 that measures and accumulates the power in the first outband OB1 of the first reception signal RX_1 that passes through the digital mixer 242 and the lowpass filter 243. In addition, the third measurement operation MO3 may include an operation of the power calculation & accumulation circuit 244 measures and accumulates the power in the second outband OB2 of the first reception signal RX_1 that passes through the digital mixer 242 and the lowpass filter 243.

In an embodiment, the first gap time GT1, the second gap time GT2, and the third gap time GT3 may set so that the digital mixer 242 or lowpass filter 243 controlled by at least one of the first control signal CF_CS and the second control signal PM_CS is stabilized against changes caused by the first control signal CF_CS and the second control signal PM_CS.

In an embodiment, for the first measurement operation MO1, the digital mixer 242 may perform frequency down-conversion on the first reception signal RX_1 based on a first center frequency corresponding to the inband IB according to the first control signal CF_CS. In addition, for the first measurement operation MO1, a value of at least one filter of the lowpass filter 243 may be changed by the second control signal PM_CS. The first gap time GT1 may be set so that the digital mixer 242 or lowpass filter 243 is stabilized in order to effectively perform the first measurement operation MO1.

In an embodiment, for the second measurement operation MO2, the digital mixer 242 may perform frequency down-conversion on the first reception signal RX_1 based on a second center frequency corresponding to the first outband OB1, based on the first control signal CF_CS. In addition, for the second measurement operation MO2, a value of at least one filter of the lowpass filter 243 may be changed by the second control signal PM_CS. The second gap time GT2 may be set so that the digital mixer 242 or lowpass filter 243 is stabilized in order to effectively perform the second measurement operation MO2.

In an embodiment, for the third measurement operation MO3, the digital mixer 242 may perform frequency down-conversion on the first reception signal RX_1, based on a third center frequency corresponding to the second outband OB2 according to the first control signal CF_CS. In addition, for the third measurement operation MO3, a value of at least one filter of the lowpass filter 243 may be changed by the second control signal PM_CS. The third gap time GT3 may be set so that the digital mixer 242 or lowpass filter 243 is stabilized in order to effectively perform the third measurement operation MO3.

In some embodiments, the first gap time GT1, the second gap time GT2, and the third gap time GT3 may be adaptively adjusted according to an operating environment of the time domain-based measurement circuit 240. For example, when the operating environment of the time domain-based measurement circuit 240 corresponds to an environment in which additional time is needed for the digital mixer 242 or lowpass filter 243 to be stabilized, the first gap time GT1, the second gap time GT2, and the third gap time GT3 may be adjusted to increase. In another example, when the operating environment of the time domain-based measurement circuit 240 corresponds to an environment in which the digital mixer 242 or lowpass filter 243 is stabilized more quickly, the first gap time GT1, the second gap time GT2, and the third gap time GT3 may be adjusted to decrease.

In an embodiment, the first gap time GT1, the second gap time GT2, and the third gap time GT3 may be set to be the same. In some embodiments, the first gap time GT1, the second gap time GT2, and the third gap time GT3 may be set to be different by individually considering the characteristics of the first measurement operation MO1, the second measurement operation MO2, and the third measurement operation MO3.

In an embodiment, the first measurement operation length ML1, the second measurement operation length ML2, and the third measurement operation length ML3 may be controlled by the third control signal L_CS of the measurement control circuit 241. In an embodiment, the first measurement operation length MI,1, the second measurement operation length ML2, and the third measurement operation length ML3 may be set to be the same. In some embodiments, the first measurement operation length ML1, the second measurement operation length ML2, and the third measurement operation length ML3 may be set to be different by individually considering the characteristics of the first measurement operation MO1, the second measurement operation MO2, and the third measurement operation MO3.

In an embodiment, the time domain-based measurement circuit 240 may generate an adjacent channel leakage ratio including a first difference and a second difference based on a result of measurement of the first measurement operation MO1, the second measurement operation MO2, and the third measurement operation MO3. For example, the time domain-based measurement circuit 240 may calculate a first difference between the measurement result of the first measurement operation MO1 and the measurement result of the second measurement operation MO2, and a second difference between the measurement result of the first measurement operation MO1 and the measurement result of the third measurement operation MO3.

An operation of measuring an adjacent channel leakage ratio in the time domain of the time domain-based measurement circuit 240, described with reference to FIG. 10 is only an example, and embodiments of the disclosure are not limited thereto. That is, the adjacent channel leakage ratio may be measured in various ways.

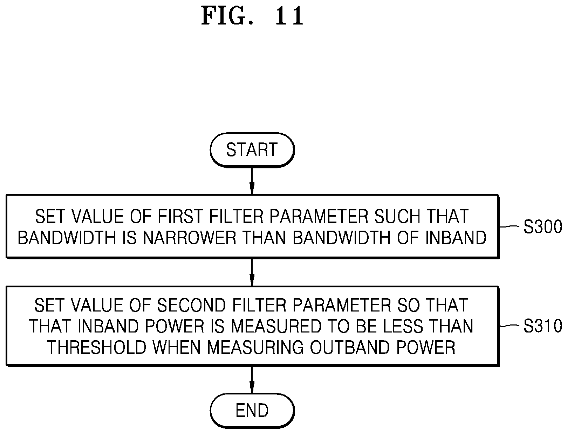

FIG. 11 is a flowchart of a method of setting a low pass filter, according to an embodiment. In FIG. 11, a method of setting the lowpass filter 243 in FIG. 8 is described.

Referring to FIG. 11, in operation S300, a value of a first filter parameter of the lowpass filter 243 may be set so that the lowpass filter 243 has a narrower bandwidth than an inband of the first reception signal RX_1 of the time domain-based measurement circuit 240. For example, the first filter parameter may be related to a bandwidth of the lowpass filter.

In operation S310, a value of a second filter parameter of the lowpass filter 243 may be set so that inband power is measured to be less than a threshold when measuring the outband power of the first reception signal RX_1 of the time domain-based measurement circuit 240. For example, the second filter parameter may be related to a degree of attenuation of the lowpass filter.

In some embodiments, the first filter parameter and the second filter parameter in FIG. 11 are initially set. When the time domain-based measurement circuit 240 operates, a value of at least one of the first and second filter parameters may be adaptively adjusted.

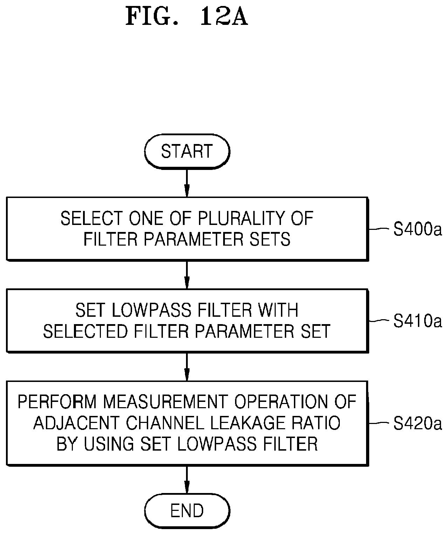

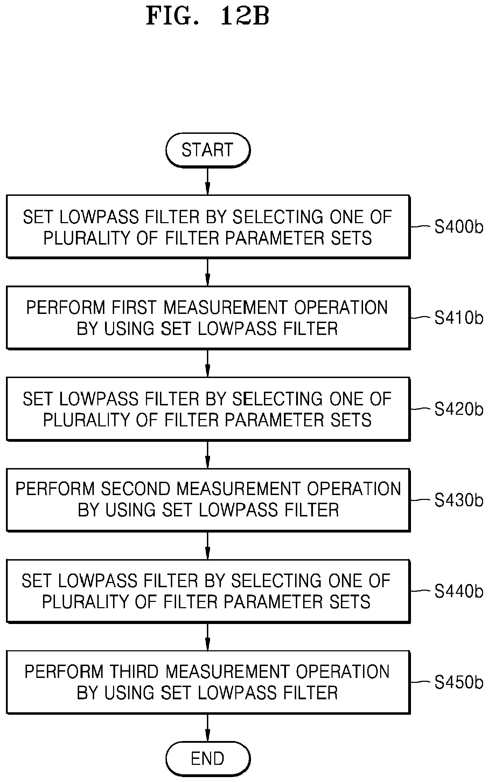

FIGS. 12A and 12B are flowcharts of operations of setting a low pass filter, according to an embodiment. In FIGS. 12A and 12B, operations of setting the lowpass filter 243 in FIG. 8 are described. In addition, in FIG. 12A, an embodiment is described in which the lowpass filter set in operation S410a is used the same during the first measurement operation MO1, the second measurement operation MO2, and the third measurement operation MO3 (e.g., shown in FIG. 10) included in a measurement operation of an adjacent channel leakage ratio for the first reception signal RX_1, and in FIG. 12B, an embodiment is described in which the lowpass filter is set for each measurement operation.

Referring to FIG. 12A, in operation S400a, the measurement control circuit 241 may select one of a plurality of filter parameter sets of the lowpass filter 243. In the disclosure, the filter parameter set may include a plurality of filter parameters having certain values of the lowpass filter 243. For example, a value of an arbitrary filter parameter included in a first filter parameter set may be different from a value of the same arbitrary filter parameter included in a second filter parameter set. The plurality of filter parameter sets may be preset, and the measurement control circuit 241 may select a filter parameter set in which an adjacent channel leakage ratio for the first reception signal RX_1 may be effectively measured in a current operating environment. Specifically, the measurement control circuit 241 may select a filter parameter set from among the plurality of filter parameter sets based on a sampling rate of the ADC 233 (see FIG. 6).

In operation S410a, the measurement control circuit 241 may set the lowpass filter with the filter parameter set selected in operation S400a.

In operation S420a, the measurement control circuit 241 a measurement operation of the adjacent channel leakage ratio for the first reception signal RX_1 may be performed by using the lowpass filter set in operation S410a.

Referring further to FIG. 12B, in operation S400b, the measurement control circuit 241 may set the lowpass filter 243 by selecting one of the plurality of filter parameter sets.

In operation S410b, the measurement control circuit 241 may perform the first measurement operation MO1 (see FIG. 10) by using the lowpass filter 243 set in operation S400b.

In operation S420b, the measurement control circuit 241 may reset the lowpass filter by selecting one of the plurality of filter parameter sets after completing the first measurement operation MO1 (see FIG. 10).

In operation S430b, the measurement control circuit 241 may perform the second measurement operation MO2 (see FIG. 10) by using the lowpass filter 243 set in operation S420b.

In operation S440b, the measurement control circuit 241 may reset the lowpass filter by selecting one of the plurality of filter parameter sets after completing the second measurement operation MO2 (see FIG. 10).

In operation S450b, the measurement control circuit 241 may perform the third measurement operation MO3 (see FIG. 10) by using the lowpass filter 243 set in operation S440b.

In an embodiment, bandwidths or attenuation degrees of the lowpass filter 243 individually, respectively set for the first measurement operation MO1, the second measurement operation MO2, and the third measurement operation MO3 (e.g., shown in FIG. 10) may be the same as or different from each other.

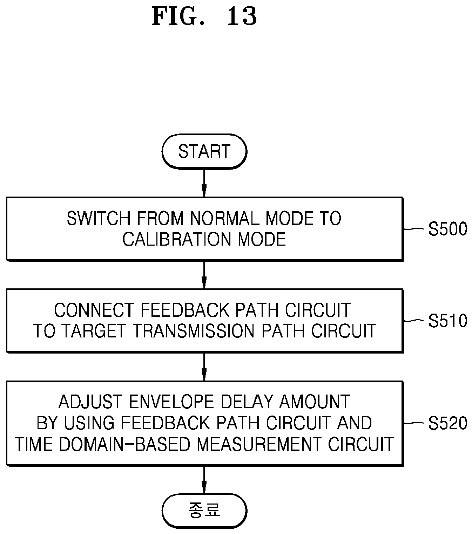

FIG. 13 is a flowchart of an operating procedure of a wireless communication device, according to an embodiment.

Referring to FIG. 13, in operation S500, the wireless communication device may switch from normal mode to calibration mode. In an embodiment, the wireless communication device may periodically switch from normal mode to calibration mode. The time period for this switching may be based on a preset time period value. In some embodiments, the wireless communication device may also switch from normal mode to calibration mode when certain conditions are met. Examples of such conditions include a request being received from the wireless network, and an internal determination that a calibration should be performed, for example based on a detection of a change of operating conditions such as a change of a transmission parameter (such as a frequency or channel) or a change in measured transmission quality.

In operation S510, the wireless communication device may connect a feedback path circuit to a target transmission path circuit from among a plurality of transmission path circuits. In the disclosure, the target transmission path circuit may refer to a transmission path circuit subject to adjustment of an envelope delay amount.

In operation S520, the wireless communication device may adjust an envelope delay amount for the target transmission path circuit by using the feedback path circuit and the time domain-based measurement circuit.

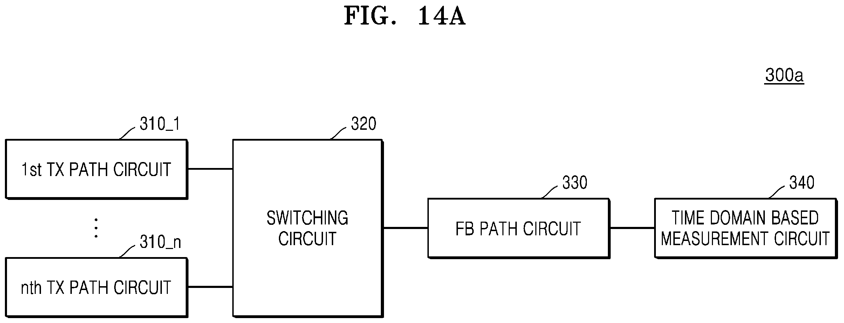

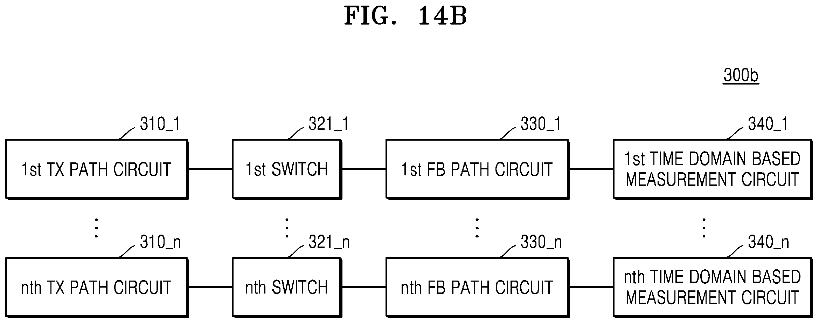

FIGS. 14A and 14B are block diagrams of an embodiment of wireless communication device 300a and 300b, according to an embodiment.

Referring to FIG. 14A, the wireless communication device 300a may include first to n-th (where n is an integer of 2 or more) transmission path circuits 310_1 to 310_n, a switching circuit 320, a feedback path circuit 330, and a time domain-based measurement circuit 340.

In an embodiment, the wireless communication device 300a may select a target transmission path circuit from among the first to n-th transmission path circuits 310_1 to 310_n, and connect the selected target transmission path circuit to the feedback path circuit 330 through the switching circuit 320. Through this operation, the feedback path circuit 330 may receive feedback from the target transmission path circuit and generate a reception signal, and the time domain-based measurement circuit 340 may generate an adjacent channel leakage ratio for the reception signal. The wireless communication device 300a may adjust an envelope delay amount for the target transmission path circuit based on the adjacent channel leakage ratio.

In an embodiment, the wireless communication device 300a may adjust envelope delay amounts for a plurality of transmission path circuits by sequentially connecting at least two of the first to n-th transmission path circuits 310_1 to 310_n to the feedback path circuit 330 through the switching circuit 320.

In an embodiment, the wireless communication device 300a may have a minimum number of feedback path circuits 330 and time domain-based measurement circuits 340 and (effectively) support an envelope delay amount adjustment operation for the first to n-th transmission path circuits 310_1 to 310_n.

Referring further to FIG. 14B, the wireless communication device 300b may include the first to n-th transmission path circuits 310_1 to 310_n, first to n-th switches 321_1 to 321_n, first to n-th feedback path circuits 330_1 to 330_n, and first to n-th time domain-based measurement circuits 340_1 to 340n. The transmission path circuits 310_1 to 310n may have a one-to-one correspondence with the feedback path circuits 330_1 to 330_n, and the feedback path circuits 330_1 to 330_n and the time domain-based measurement circuits 340_1 to 340_n may also have a one-to-one correspondence with each other.

In an embodiment, the wireless communication device 300b may connect the transmission path circuits 310_1 to 310n to the feedback path circuits 330_1 to 330_n through the switches 321_1 to 321_n, respectively. The wireless communication device 300b may perform operations for adjusting envelope delay amounts for a plurality of target transmission path circuits from among the first to n-th transmission path circuits 310_1 to 310_n in parallel by using the first to n-th switches 321_1 to 321_n, the first to n-th feedback path circuits 330_1 to 330_n, and the first to n-th time domain-based measurement circuits 340_1 to 340n. For example, the wireless communication device 300b may perform an operation of adjusting an envelope delay amount for the first transmission path circuit 310_1 and an operation of adjusting an envelope delay amount for the n-th transmission path circuit 310_n in parallel.

In an embodiment, the wireless communication device 300b may adjust the envelope delay amounts for the plurality of transmission path circuits, thereby minimizing a time required in the calibration mode.

However, embodiments of the wireless communication device 300a and 300b shown in FIGS. 14A and 14B are only examples, and embodiments are not limited thereto, and the wireless communication device 300a and 300b may be variously implemented to perform a calibration operation on the envelope delay amount according to the technical ideas of the disclosure.

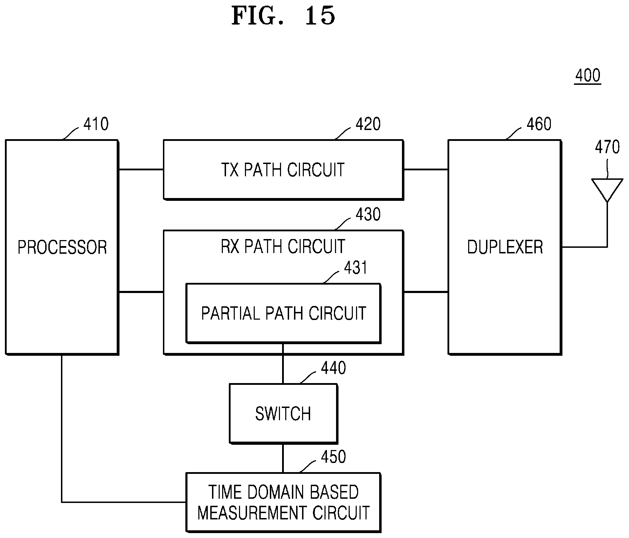

FIG. 15 is a block diagram of another embodiment of a wireless communication device 400, according to an embodiment.

Referring to FIG. 15, the wireless communication device 400 may include a processor 410, a transmission path circuit 420, a reception path circuit 430, a switch 440, a time domain-based measurement circuit 450, a duplexer 460, and an antenna 470.

In an embodiment, the reception path circuit 430 is configured to receive an RF input signal and may include a partial path circuit 431 configured the same or similar to the feedback path circuit 130 in FIG. 1. In other words, the wireless communication device 400 in FIG. 15 may use the partial path circuit 431 including a part of elements of the reception path circuit 430 as a feedback path circuit instead of having an additional feedback path circuit, and perform a calibration operation according to embodiments. This allows the techniques discussed herein to be performed, without additional complexity that may be associated with the inclusion of additional components in the device.

In an embodiment, the partial path circuit 431 may include a front-end circuit, an RFIC, an ADC, and a plurality of processing circuits of the reception path circuit 430.

In an embodiment, the partial path circuit 431 may be connected to the transmission path circuit 420 through the duplexer 460 to receive a feedback signal, similar to the feedback path circuit described above, and generate a reception signal.

In an embodiment, the time domain-based measurement circuit 450 may be connected to the partial path circuit 431 through the switch 440, and generate an adjacent channel leakage ratio for the reception signal generated by the partial path circuit 431.

In an embodiment, the processor 410 may adjust an envelope delay amount for the transmission path circuit 420 based on the adjacent channel leakage ratio generated by the time domain-based measurement circuit 450.

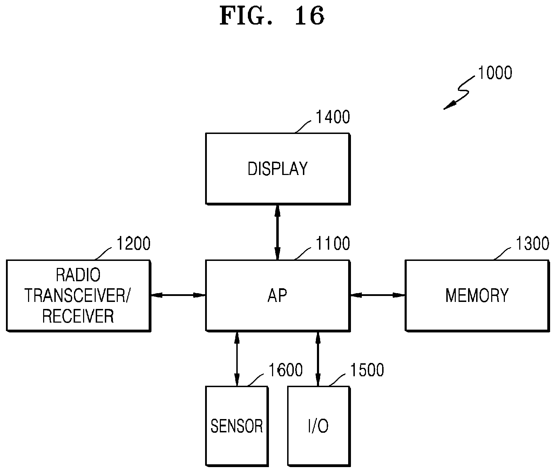

FIG. 16 is a block diagram of an Internet of Things (IoT) device 1000, which is an example of a wireless communication device, according to an embodiment.

Referring to FIG. 16, IoT may refer to a network between objects using wired/wireless communication. IoT devices have an accessible wired or wireless interface and may include devices that transmit and receive data by communicating with at least one other device through the wired or wireless interface. The accessible interface of IoT devices may include modem communication interfaces capable of accessing wired local area networks (LAN), wireless local area networks (WLAN) such as Wi-Fi, wireless personal area network (WPAN) such as Bluetooth, wireless universal serial bus (USB), Zigbee, near-field communication (NFC), radio-frequency identification (RFID), power line communication (PLC), or mobile cellular networks such as third generation (3G), LTE, and fourth generation (4G), fifth-generation (5G). The Bluetooth interface may support Bluetooth Low Energy (BLE).

Specifically, the IoT device 1000 may include a radio transmitter/receiver (or, transceiver) 1200 for communicating with the outside. The radio transmitter/receiver 1200 may be, for example, a modem communication interface capable of accessing a LAN, a wireless short-range communication interface such as Bluetooth, Wi-Fi, or Zigbee, a PLC, or a mobile communication network such as 3G, LTE, 4G, or 5G. The radio transmitter/receiver 1200 may include a transmitter and/or a receiver.

The IoT device 1000 may transmit and/or receive information from an access point or gateway through the radio transmitter/receiver 1200. In addition, the IoT device 1000 may communicate with user equipment or another IoT device to transmit and/or receive control information or data of the IoT device 1000.

In the radio transmitter/receiver 1200, a feedback reception path and a time domain-based measurement circuit according to the embodiments described above may be implemented and used to adjust an envelope delay amount for a target transmission path circuit of the transmitter.

The IoT device 1000 may further include a processor or application processor (AP) 1100 that performs calculations.

The AP 1100 may control the radio transmitter/receiver 1200 to generate an adjacent channel leakage ratio according to the embodiments described above. In addition, the AP 1100 may adjust the envelope delay amount for the target transmission path circuit based on the adjacent channel leakage ratio measured from the radio transmitter/receiver 1200.

The IoT device 1000 may have a built-in battery for internal power supply or may further include a power supply unit configured to receive power from the outside. In addition, the IoT device 1000 may include a display 1400 for displaying internal status or data. A user may control the IoT device 1000 through a user interface (UI) of the display 1400. The IoT device 1000 may transmit internal state and/or data to the outside through the radio transmitter/receiver 1200, or may receive control commands and/or data from the outside through the radio transmitter/receiver 1200.

A memory 1300 may store control instruction codes, control data, or user data for controlling the IoT device 1000. The memory 1300 may include at least one of volatile memory or non-volatile memory. The non-volatile memory may include at least one of various memories, including read only memory (ROM), programmable ROM (PROM), electrically programmable ROM (EPROM), electrically erasable and programmable ROM (EEPROM), flash memory, phase-change RAM (PRAM), magnetic RAM (MRAM), resistive RAM (ReRAM), ferroelectric RAM (FRAM), etc. The volatile memory may include at least one of various memories such a dynamic RAM (DRAM), static RAM (SRAM), and synchronous DRAM (SDRAM).

In the memory 1300, codes or commands defining operations of generating an adjacent channel leakage ratio and adjusting an envelope delay amount in calibration mode according to the embodiments described above may be stored. The AP 1100 or radio transmitter/receiver 1200 may access the memory 1300 and execute the stored corresponding codes or commands, to perform an operation according to the embodiments described above.

The IoT device 1000 may further include a storage device. The storage device may include at least one of non-volatile media, including a hard disk drive (HDD), solid state drive (SSD), embedded multimedia card (eMMC), and universal flash storage (UFS). The storage device may store user information provided through an input/output unit (I/O) 1500 and sensing information collected through a sensor 1600.

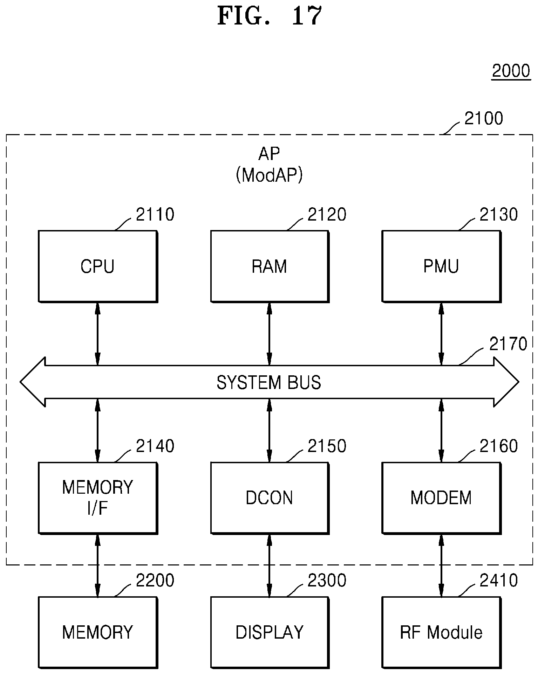

FIG. 17 is a block diagram of user equipment 2000 to which a wireless communication device is applied, according to an embodiment.

Referring to FIG. 17, the user equipment 2000 may include an AP 2100, a memory 2200, a display 2300, and an RF module 2410. In addition, the user equipment 2000 may further include various elements such as a lens, sensor, and audio module.

The AP 2100 may be implemented as a system on chip (SoC), and may include a central processing unit (CPU) 2110, RAM 2120, a power management unit (PMU) 2130, a memory interface (I/F) 2140, a display controller (DCON) 2150, a modem 2160, and system bus 2170. The AP may further include various Intellectual Properties (IPs). The AP 2100 may be referred to as ModAP as a function of a modem chip is integrated therein.

The CPU 2110 may generally control operations of the AP 2100 and the user equipment 2000. The CPU 2110 may control an operation of each element of the AP 2100. In addition, the CPU 2110 may be implemented as multi-core. The multi-core is a computing component with two or more independent cores. The RAM 2120 may temporarily store programs, data, or instructions. For example, programs and/or data stored in the memory 2200 may be temporarily stored in the RAM 2120 according to control of the CPU 2110 or booting code. The RAM 2120 may be implemented as DRAM or SRAM.

The PMU 2130 may manage power of each element of the AP 2100. The PMU 2130 may also determine operating status of each component of the AP 2100 and control the operation.

The memory I/F 2140 may generally control an operation of the memory 2200 and may control data exchange between each element of the AP 2100 and the memory 2200. The memory I/F 2140 may write data onto the memory I/F 2140 or read data from the memory 2200 according to a request from the CPU 2110.

The DCON 2150 may transmit, to the display 2300, image data to be displayed on the display 2300. The display 2300 may be implemented as a flat display such as a liquid crystal display (LCD) or organic light emitting diode (OLED), or as a flexible display.

For wireless communication, the modem 2160 may modulate data to be transmitted to suit a wireless environment, and recover the received data. The modem 2160 may perform digital communication with the RF module 2410.

This modem 2160 may be implemented to control or perform an operation of adjusting an envelope delay amount for a target transmission path circuit within the RF module 2410 according to the embodiments described above.

The RF module 2410 may convert a high frequency signal received through an antenna into a low frequency signal, and transmit the converted low frequency signal to the modem 2160. In addition, the RF module 2410 may convert the low frequency signal received from the modem 2160 into a high frequency signal, and transmit the converted high frequency signal to the outside of the user equipment 2000 through the antenna. In addition, the RF module 2410 may amplify and filter a signal. In this RF module 2410, a feedback path circuit and a time domain-based measurement circuit according to the embodiments described above may be implemented.

While the disclosure has been particularly shown and described with reference to embodiments thereof, it will be understood that various changes in form and details may be made therein without departing from the scope of the following claims.

## Claims

1. A wireless communication device comprising:
at least one processor configured to output a first transmission signal, and delay a first envelope signal corresponding to the first transmission signal by an envelope delay amount and output the delayed first envelope signal;
a transmission path circuit configured to generate a first radio frequency (RF) output signal, based on the first transmission signal and a supply voltage tracking the first envelope signal;
a feedback path circuit configured to generate a first reception signal by receiving the first RF output signal as a first feedback signal; and
a time domain-based measurement circuit configured to generate an adjacent channel leakage ratio for the first reception signal in a time domain,
wherein the at least one processor is further configured to adjust the envelope delay amount, based on the adjacent channel leakage ratio.

2. The wireless communication device of claim 1, wherein the feedback path circuit is further configured to generate a second reception signal by receiving a second RF output signal from the transmission path circuit, and
wherein the second reception signal is used to adjust a value of at least one transmission parameter of the transmission path circuit.

3. The wireless communication device of claim 2, wherein the feedback path circuit comprises:
an analog-to-digital converter configured to perform analog-to-digital conversion on the received feedback signal; and
a plurality of processing circuits connected to each other to sequentially process the converted feedback signal,
wherein the first reception signal comprises a signal output by passing through a part of the plurality of processing circuits, and
wherein the second reception signal comprises a signal output by passing all of the plurality of processing circuits.

4. The wireless communication device of claim 3, wherein the part of the plurality of processing circuits comprise at least one of a direct current (DC) offset calibration circuit and an inphase/quadrature (I/Q) mismatch calibration circuit.

5. The wireless communication device of any preceding claim, wherein the time domain-based measurement circuit is further configured to:
perform a plurality of frequency down-conversions on the first reception signal based on a plurality of center frequencies;
perform lowpass filtering based on the performed plurality of frequency down-conversions;
measure inband power, first outband power, and second outband power based on the performed lowpass filtering; and
generate the adjacent channel leakage ratio, based on the measured inband power, first outband power, and second outband power.

6. The wireless communication device of any preceding claim, wherein the time domain-based measurement circuit is further configured to:
perform a first frequency down-conversion on the first reception signal based on a first center frequency;
perform lowpass filtering on a first conversion result comprising a result of the first frequency down-conversion, and perform a first measurement operation for measuring inband power by using a result of the lowpass filtering on the first frequency down-conversion;
perform a second frequency down-conversion on the first reception signal based on a second center frequency, perform lowpass filtering on a second conversion result comprising a result of the second frequency down-conversion, and perform a second measurement operation for measuring first outband power by using a result of the lowpass filtering on the second frequency down-conversion; and
perform a third frequency down-conversion on the first reception signal based on a third center frequency, perform lowpass filtering on a third conversion result comprising a result of the third frequency down-conversion, and perform a third measurement operation for measuring second outband power by using a result of the lowpass filtering on the third frequency down-conversion.

7. The wireless communication device of claim 6, wherein the time domain-based measurement circuit is further configured to:
perform the first measurement operation after a first gap time from an output time point of the first RF output signal in the transmission path circuit;
perform the second measurement operation after a second gap time from a completion time point of the first measurement operation; and
perform the third measurement operation after a third gap time from a completion time point of the second measurement operation.

8. The wireless communication device of claim 7, wherein the output time point of the first RF output signal corresponds to a slot boundary of the first RF output signal or a transmit time interval (TTI) boundary of the first RF output signal.

9. The wireless communication device of any of claims 6 to 8, wherein the time domain-based measurement circuit is further configured to:
select at least one filter parameter set from among a plurality of filter parameter sets, and
apply the selected at least one filter parameter set to lowpass filtering for the first conversion result, the second conversion result, and the third conversion result.

10. The wireless communication device of any preceding claim, wherein the time domain-based measurement circuit comprises:
a digital mixer configured to perform frequency down-conversion on the first reception signal;
a lowpass filter configured to perform lowpass filtering based on the performed frequency down-conversion;
a power calculation and accumulation circuit configured to calculate and accumulate powers of a result of the lowpass filtering; and
a measurement control circuit configured to generate the adjacent channel leakage ratio, based on the calculated and accumulated powers.

11. The wireless communication device of claim 10, wherein the measurement control circuit is further configured to generate at least one of a first control signal for controlling a center frequency of the digital mixer, a second control signal for controlling filter parameters of the lowpass filter, and a third control signal for controlling an operation length of the power calculation and accumulation circuit.

12. The wireless communication device of claim 10 or claim 11, wherein values of a plurality of filter parameters of the lowpass filter are set so that the lowpass filter has a narrower bandwidth than an inband of the first reception signal, and are set so that inband power of the first reception signal of the first reception signal is measured to be less than a threshold, based on measured outband power of the first reception signal.

13. The wireless communication device of any preceding claim, wherein the adjacent channel leakage ratio comprises:
a first difference between inband power of the first reception signal and first outband power of the first reception signal; and
a second difference between the inband power and second outband power of the first reception signal, and
wherein the at least one processor is further configured to adjust the envelope delay amount, based on the first difference and the second difference.

14. The wireless communication device of any preceding claim, wherein the at least one processor is further configured to switch from normal mode to calibration mode and connect the feedback path circuit to the transmission path circuit.

15. The wireless communication device of any preceding claim, further comprising a reception path circuit configured to receive an radio frequency (RF) input signal, and
wherein the feedback path circuit is configured to comprise part of the reception path circuit.
